# FASCICULE DE BREVET EUROPEEN

(11) **EP 4 229 724 B1**
(45) Date de publication et mention de la délivrance du brevet: **10.07.2024**
(21) Numéro de dépôt: 21777571.7
(22) Date de dépôt: 27.08.2021
(51) Int. Cl.: H01S 5/024, G02B 6/12, H01S 5/02, H01S 5/026, H01S 5/042, H01S 5/10

(54) **DISPOSITIF PHOTONIQUE AVEC DISSIPATION THERMIQUE AMELIOREE POUR LASER HETEROGENE III-V/SI ET PROCEDE DE FABRICATION ASSOCIE**
PHOTONISCHE VORRICHTUNG MIT VERBESSERTER WÄRMEABLEITUNG FÜR HETEROGENEN III-V/SI-LASER UND ZUGEHÖRIGES HERSTELLUNGSVERFAHREN
PHOTONIC DEVICE WITH IMPROVED HEAT DISSIPATION FOR III-V/SI HETEROGENEOUS LASER AND ASSOCIATED MANUFACTURING METHOD

(30) Priorité: 16.10.2020 FR 2010606
(43) Date de publication de la demande: 23.08.2023
(73) Titulaire: Scintil Photonics, 38040 Grenoble Cedex 9 (FR)
(72) Inventeur: MENEZO, Sylvie, 38500 VOIRON (FR)
(74) Mandataire: IP Trust
(86) Numéro de dépôt international: PCT/FR2021/051494
(87) Numéro de publication internationale: WO 2022/079363

(56) Documents cités:
- EP-A1- 2 685 297
- EP-A1- 3 015 888
- US-A1- 2014 376 857
- DUREL JOCELYN ET AL: "Realization of back-side heterogeneous hybrid III-V/Si DBR lasers for silicon photonics", PROCEEDINGS OF SPIE; [PROCEEDINGS OF SPIE ISSN 0277-786X VOLUME 10524], SPIE, US, vol. 9750, 29 February 2016 (2016-02-29), pages 97500O - 97500O, XP060068815, ISBN: 978-1-5106-1533-5, DOI: 10.1117/12.2212309
- ZHANG CHONG ET AL: "Thermal Management of Hybrid Silicon Ring Lasers for High Temperature Operation", IEEE JOURNAL OF SELECTED TOPICS IN QUANTUM ELECTRONICS, IEEE SERVICE CENTER, PISCATAWAY, NJ, US, vol. 21, no. 6, 1 November 2015 (2015-11-01), pages 1 - 7, XP011585819, ISSN: 1077-260X, [retrieved on 20150626], DOI: 10.1109/JSTQE.2015.2428057

## Description

### DOMAINE DE L'INVENTION

La présente invention concerne les domaines de la microélectronique, l'optique, l'électro-optique et la photonique. Elle concerne en particulier un dispositif photonique comprenant un premier guide d'onde optique et un deuxième guide d'onde, intégrés dans une couche optique ; le premier guide d'onde est associé à un empilement de semi-conducteurs III-V pour former une source laser. Le dispositif photonique selon l'invention comprend une couche intermédiaire structurée, entre la couche optique et une couche support, qui favorise notamment la dissipation thermique entre la source laser et la couche support.

### ARRIERE PLAN TECHNOLOGIQUE DE L'INVENTION

Au cours des dernières années, de nombreuses solutions et architectures ont été développées pour la fabrication de lasers hétérogènes (ou hybrides) III-V sur Si, utilisant les plateformes technologiques silicium largement disponibles et éprouvées de l'industrie microélectronique.

Les substrats SOI (silicium sur isolant) sont couramment utilisés pour l'élaboration de dispositifs photoniques. La couche superficielle en silicium permet la construction de guides d'onde et potentiellement d'autres éléments tels que des coupleurs optiques par la tranche, des modulateurs, des détecteurs, etc. L'oxyde enterré du substrat SOI assure quant à lui le rôle de gaine, limitant les pertes optiques dans le substrat sous-jacent en silicium. Afin de garantir une bonne qualité de gainage optique pour tous les éléments du dispositif photonique, l'oxyde enterré présente habituellement une épaisseur comprise entre 1 et 3 microns. Un empilement de couches actives en matériaux III-V peut ensuite être assemblé sur le guide d'onde, avec ou sans couche intercalaire, selon les approches. En fonctionnement, l'empilement III-V subit un échauffement, qui, s'il n'est pas maîtrisé par des solutions de dissipation thermique, affecte les performances du laser. Bien que le substrat support en silicium d'un substrat SOI présente une conductibilité thermique très favorable, la couche épaisse d'oxyde enterré, sous le guide d'onde, constitue une barrière significative à la dissipation thermique entre l'empilement III-V et le substrat support.

Cet effet de barrière thermique de l'oxyde enterré d'un substrat SOI est par exemple mis en évidence dans la publication de M.N. Sysak et al (« Hybrid silicon laser technology : a thermal perspective », IEEE Journal of selected topics in quantum electronics, VOL.17, n°6, p. 1490-1498 Nov/Dec. 2011). La solution proposée dans ce document consiste à former des ponts thermiques en poly-silicium segmentant l'oxyde enterré et établissant des chemins verticaux de dissipation thermique jusqu'au substrat sous-jacent. Bien sûr, ces ponts ne peuvent pas être directement à l'aplomb de l'empilement III-V, car l'oxyde enterré est requis pour le gainage optique : ils sont décalés à l'aplomb d'une région périphérique de l'empilement.

C.Zhang et al (« Thermal management of hybrid silicon ring lasers for high température operation", IEEE Journal of selected topics in quantum electronics, VOL.21, n°6, Nov/Dec. 2015) propose une autre approche pour maîtriser la dissipation thermique d'un laser hybride sur SOI. Elle consiste à réaliser un pont métallique entre un contact électrique de l'empilement III-V et le substrat support en silicium du SOI, en périphérie dudit empilement. A cet endroit, la couche superficielle et l'oxyde enterré du SOI sont donc gravés, donnant directement accès au substrat support ; là encore les ponts thermiques sont décalés à l'aplomb d'une région périphérique de l'empilement.

Le document US2014376857 propose une autre solution d'intégration basée sur des niveaux interconnectés de métallisations aménagés dans une couche isolante, en dessous du guide d'onde, et jouant le rôle de dissipateurs thermiques. Partant d'un substrat SOI, un guide d'onde est formé dans la couche superficielle en silicium et lesdits niveaux de métallisation sont élaborés au-dessus et/ou de part et d'autre du guide d'onde, encapsulés dans une couche isolante. Ladite couche isolante est ensuite assemblée sur un substrat cible. Le substrat support ainsi que l'oxyde enterré du SOI sont retirés. L'empilement de couches actives III-V est assemblé sur la face arrière de la couche superficielle, à l'aplomb du guide d'onde. Les niveaux interconnectés de métallisations améliorent la performance de dissipation thermique entre le guide d'onde et le substrat cible, et plus généralement entre ce dernier et l'empilement de couches actives du laser. Là encore les ponts thermiques sont principalement décalés à l'aplomb d'une région périphérique de l'empilement.

EP 3 015 888 A1 décrit un dispositif photonique hybride à semi-conducteurs III-V sur guide d'onde silicium, comprenant en particulier une couche intermédiaire entre une couche optique isolante comprenant le guide d'onde et une couche support.

### OBJET DE L'INVENTION

La présente invention propose une solution alternative aux solutions de l'état de la technique. Elle concerne en particulier un dispositif photonique comprenant un premier guide d'onde optique et un deuxième guide d'onde optique, intégrés dans une couche optique, le premier guide d'onde étant associé à un empilement en composés semi-conducteurs III-V pour former un laser hétérogène III-V/Si ; le dispositif photonique comprend une couche intermédiaire, entre la couche optique et une couche support, qui favorise la dissipation thermique entre le laser et la couche support. Dans cette alternative, contrairement aux solutions de l'état de l'art, les ponts thermiques sont disposés à l'aplomb du laser. L'invention concerne également un procédé de fabrication dudit dispositif photonique.

### BREVE DESCRIPTION DE L'INVENTION

La présente invention concerne un dispositif photonique comprenant :
- une couche support,
- une couche optique s'étendant selon un plan principal, subdivisée au moins en une première région et une deuxième région, adjacentes dans ledit plan principal, et comportant un premier guide d'onde optique dans la première région et un deuxième guide d'onde optique dans la deuxième région,
- un empilement en composés semi-conducteurs III-V, disposé sur une couche diélectrique, elle-même disposée sur le premier guide d'onde, dans la première région, l'empilement formant avec le premier guide d'onde optique une source laser,
- une couche intermédiaire, entre la couche optique et la couche support, comprenant un matériau conducteur thermique formant un pavé monobloc, disposé à l'aplomb de la première région et un matériau de gainage optique et/ou électrique disposé à l'aplomb de la deuxième région.

Selon des caractéristiques avantageuses de l'invention, prises seules ou selon toute combinaison réalisable :
- le matériau conducteur thermique présente une conductibilité thermique supérieure ou égale à 10 W/m/K, à 20 W/m/K, à 50 W/m/K, voire à 100 W/m/K ;
- le matériau de gainage est choisi parmi l'oxyde de silicium ou l'air, et le matériau conducteur thermique est choisi parmi le silicium, le nitrure de silicium, le cuivre, le nitrure d'aluminium, l'aluminium, l'alumine ;
- le premier guide d'onde optique comprend du silicium monocristallin, du silicium amorphe et/ou du nitrure de silicium ;
- la couche support est en silicium monocristallin ;
- le matériau conducteur thermique et le matériau de gainage présentent une épaisseur comprise entre 100nm et 5 microns, préférentiellement entre 300nm et 3 microns ;
- le dispositif photonique comprend une interface de collage s'étendant parallèlement au plan principal, située dans la couche intermédiaire, ou entre la couche intermédiaire et la couche support, ou entre la couche intermédiaire et la couche optique ;
- le deuxième guide d'onde fait partie d'un composant optique passif, tel qu'un coupleur de lumière par la tranche, ou d'un composant optique actif, tel qu'un détecteur ou un modulateur ;
- la couche optique et/ou la couche intermédiaire comprend au moins un niveau d'interconnexion métallique pour former des contacts électriques d'un composant optique actif, et/ou pour former au moins un via de dissipation thermique entre le premier guide d'onde et le matériau conducteur thermique ;
- le dispositif photonique comprend au moins un via de dissipation thermique entre l'empilement semi-conducteur et le niveau d'interconnexion métallique ;
- le -au moins un- via de dissipation thermique comprend un matériau choisi parmi le tungstène, l'aluminium ou le cuivre.

L'invention concerne également un procédé de fabrication d'un dispositif photonique comprenant les étapes suivantes :
a) la fourniture d'un substrat silicium sur isolant comprenant une couche superficielle en silicium monocristallin présentant une face avant et une face arrière, une couche diélectrique enterrée disposée contre la face arrière de la couche superficielle, et un substrat de base ;
b) la fourniture d'une couche support ;
c) l'élaboration d'une couche optique comprenant :
   - un premier guide d'onde optique dans une première région, ledit guide d'onde étant formé dans la couche superficielle,
   - un deuxième guide d'onde optique, dans une deuxième région ;
d) la formation d'une couche intermédiaire disposée sur la couche optique ou sur la couche support ou partiellement sur la couche optique et partiellement sur la couche support, ladite couche intermédiaire comprenant un matériau conducteur thermique formant un pavé monobloc, et un matériau de gainage optique et/ou électrique ;
e) l'assemblage du substrat silicium sur isolant et de la couche support le long d'une interface de collage, la couche intermédiaire étant disposée entre la couche support et la couche optique, le matériau conducteur thermique étant disposé à l'aplomb de la première région et le matériau de gainage optique et/ou électrique étant disposé à l'aplomb de la deuxième région ;
f) le retrait du substrat de base ;
g) la formation de l'empilement sur la couche diélectrique, dans la première région.

Selon des caractéristiques avantageuses de l'invention, prises seules ou selon toute combinaison réalisable :
- la formation de la couche intermédiaire sur la couche support de l'étape d) comprend une gravure locale de la couche support, dans une zone destinée à être assemblée en vis-à-vis de la deuxième région de la couche superficielle lors de l'étape e) ;
- la formation de la couche intermédiaire sur la couche support de l'étape d) comprend optionnellement, un dépôt d'un matériau de gainage dans la zone gravée de la couche support ;
- une couche de collage est déposée sur la couche intermédiaire et/ou sur la couche optique, préalablement à l'étape e) d'assemblage.

### BREVE DESCRIPTION DES DESSINS

D'autres caractéristiques et avantages de l'invention ressortiront de la description détaillée qui va suivre en référence aux figures annexées sur lesquelles :
[Fig. 1a]

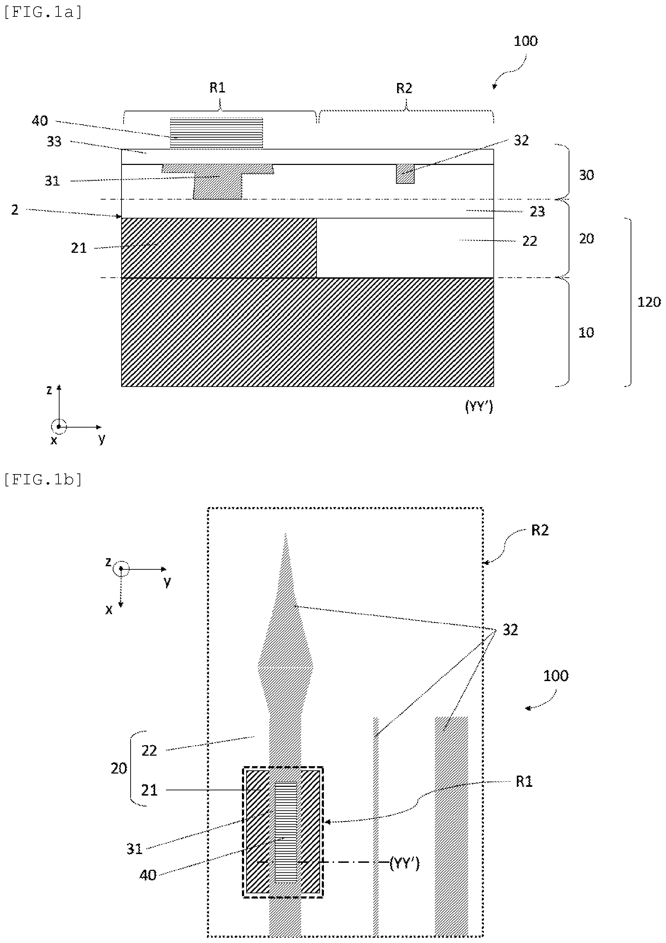

[Fig. 1b] Les figures 1a et 1b présentent respectivement une vue en coupe selon (YY') et une vue plane d'un dispositif photonique conforme à l'invention ;
[Fig. 2a]

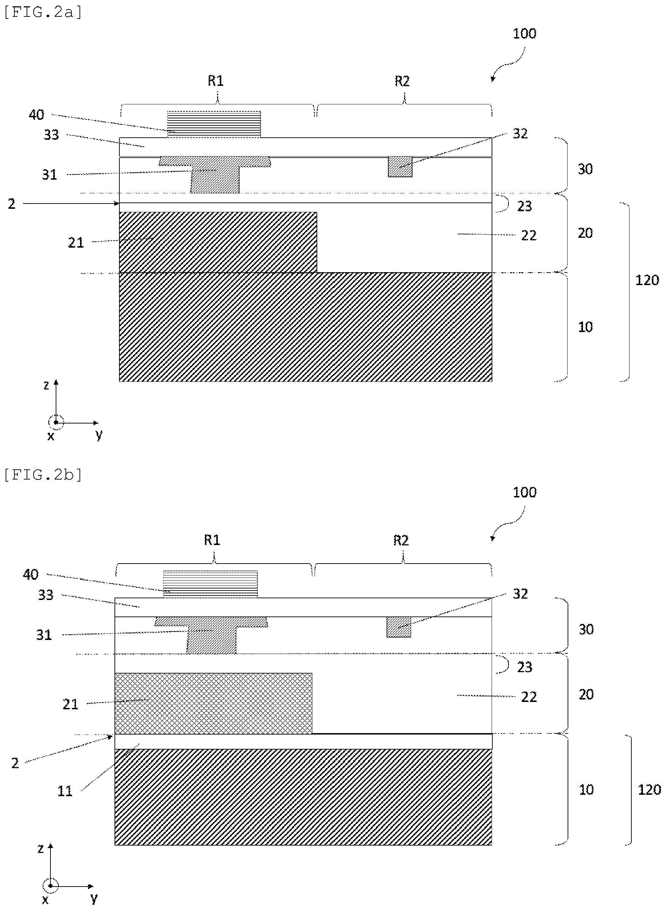

[Fig. 2b] Les figures 2a et 2b présentent un premier et un deuxième mode de réalisation d'un dispositif photonique conforme à l'invention ;
[Fig. 3a]
[Fig. 3b]
[Fig. 3c]
[Fig. 3d] Les figures 3a à 3d présentent plusieurs variantes d'un troisième mode de réalisation d'un dispositif photonique conforme à l'invention ;
[Fig. 4] La figure 4 présente des étapes du procédé de fabrication d'un dispositif photonique, conforme à la présente invention.

Les mêmes références sur les figures pourront être utilisées pour des éléments de même nature. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

Les différentes possibilités (variantes et modes de réalisation illustrés et/ou détaillés dans la description à suivre) doivent être comprises comme n'étant pas exclusives les unes des autres et peuvent se combiner entre elles, même si toutes les combinaisons ne sont pas évoquées dans la description.

### DESCRIPTION DETAILLEE DE L'INVENTION

L'invention concerne un dispositif photonique 100 comprenant une couche optique 30 s'étendant selon un plan principal (x,y), et subdivisée en une pluralité de régions R1,R2 adjacentes dans ledit plan principal comme cela est illustré sur la figure 1a. La couche optique 30 comporte au moins un premier guide d'onde optique 31 destiné à être associé à un empilement en composés semi-conducteurs III-V 40 pour former une source laser dans une première région R1. En particulier, l'empilement 40 intègre une couche inférieure présentant un dopage de type N, une couche active et une couche supérieure présentant un dopage de type P ; des plots de contact (non représentés) sont respectivement connectés à la couche inférieure et à la couche supérieure. La couche active génère un signal optique lorsqu'une différence de potentiel appropriée est appliquée entre les plots de contact. L'empilement 40 est couplé optiquement au premier guide d'onde 31, dans la première région R1. Pour cela, elle est disposée au-dessus dudit guide 31 et peut être séparée de lui par une couche diélectrique 33. L'empilement 40 et le premier guide d'onde 31 forment ainsi un guide d'onde hybride III-V/Si. Dans un guide d'onde hybride III-V/ Si, le mode optique est naturellement tiré vers le haut (selon l'axe z) : une plus faible épaisseur de matériau de gainage optique est donc en général requise sous le premier guide d'onde 31, dans la première région R1.

Le premier guide d'onde optique 31 peut comprendre des matériaux choisis parmi le silicium monocristallin, le silicium amorphe et/ou le nitrure de silicium.

La couche optique 30 comporte également au moins un deuxième guide d'onde optique 32, qui n'est pas associé à une source laser. Le deuxième guide d'onde 32 peut par exemple correspondre à un coupleur de lumière par la tranche prolongeant le premier guide d'onde 31 ou à un autre guide d'onde indépendant du premier (figure 1b). Ce deuxième guide d'onde 32 peut par exemple être en silicium ou en nitrure de silicium (SiNx).

La figure 1b présente une vue plane d'au moins une partie du dispositif photonique 100 : la première région R1, qui s'étend dans le plan principal (x,y), englobe la zone où sont associés le premier guide d'onde optique 31 et l'empilement 40. La deuxième région R2 englobe les autres zones du dispositif 100 dans lesquelles il n'y a pas de composés semi-conducteurs III-V au-dessus : sur la figure 1b, cette deuxième région R2 correspond à la zone interne au pourtour pointillé référencé R2, à l'exclusion de la première région R1.

Par la suite, nous parlerons d'un premier guide d'onde optique 31 et d'un deuxième guide d'onde optique 32 par souci de simplification, étant entendu que la couche optique 30 du dispositif 100 peut en inclure une pluralité.

Le dispositif photonique 100 comprend également une couche support 10, préférentiellement en silicium monocristallin. Le silicium présente l'avantage, en plus de sa compatibilité avec les lignes de fabrication microélectronique, de présenter un coefficient de dissipation thermique élevé, favorable à l'évacuation de la chaleur générée par la source laser, en particulier par l'empilement 40.

Entre la couche support 10 et la couche optique 30, le dispositif photonique 100 comprend une couche intermédiaire 20 formée d'au moins deux matériaux.

La couche intermédiaire 20 comprend un matériau conducteur thermique 21 formant un pavé monobloc, disposé à l'aplomb de la première région R1 et un matériau de gainage optique et/ou électrique 22 disposé à l'aplomb de la deuxième région R2. L'épaisseur de ces deux matériaux 21,22 est ajustable, selon le type et les caractéristiques du dispositif photonique 100. Le matériau conducteur thermique 21 et le matériau de gainage 22 présentent typiquement une épaisseur, selon l'axe z sur les figures, comprise entre 100nm et 5 microns, et préférentiellement entre 300nm et 3 microns.

Le matériau conducteur thermique 21 assure une dissipation efficace par sa présence uniforme en-dessous de la source laser 40. Avantageusement, on vise un matériau qui présente une conductibilité thermique supérieure ou égale à 10 W/m/K, à 20 W/m/K, à 50 W/m/K, voire à 100 W/m/K. Le matériau conducteur thermique 21 peut par exemple être choisi par exemple le silicium, le nitrure de silicium, le nitrure d'aluminium l'alumine, le cuivre ou l'aluminium.

Le matériau de gainage 22 assure la fonction de gaine optique sous le deuxième guide d'onde 32, dans la deuxième région R2. Ce matériau présente un indice optique inférieur à celui du matériau formant le deuxième guide d'onde 32, et évite notamment un couplage, avec la couche support 10, du signal optique destiné à se propager dans le deuxième guide d'onde 32. La présence d'une forte épaisseur de matériau de gainage optique 22 est particulièrement favorable dans le cas d'un coupleur de lumière par la tranche, pour éloigner le guide d'onde optique 32 de la couche support 10 sous-jacente et empêcher des fuites optiques dans la couche support 10. Dans le cas où le deuxième guide d'onde 32 fait partie d'un composant optique actif, tel qu'un détecteur ou un modulateur, l'épaisseur de matériau de gainage 22 est également adaptée pour éliminer ou tout au moins pour réduire drastiquement les capacités parasites susceptibles de s'établir entre le composant et la couche support 10.

Le matériau de gainage optique et/ou électrique 22 est avantageusement de l'oxyde de silicium ; il peut également être de l'air. Son épaisseur, comprise entre 100nm et 5 microns, et préférentiellement entre 300nm et 3 microns, permet de former un revêtement de gainage optique efficace pour une grande variété de guides d'onde optique 32 ou autres composants optiques, et procure ainsi une grande flexibilité d'architecture du dispositif photonique 100.

Comme cela est visible sur les figures 1a, 2a et 2b, la couche intermédiaire 20 peut également comprendre une couche uniforme 23 directement en contact avec la couche optique 30. Cette couche est appelée uniforme en ce qu'elle s'étend dans toutes les première et deuxième régions R1,R2 du dispositif 100. Cette couche uniforme 23 est avantageusement formée d'un matériau présentant un indice optique inférieur à celui du matériau formant les premier 31 et deuxième 32 guides d'onde, par exemple de même nature que le matériau de gainage optique 22.

Avantageusement, la couche uniforme 23 présente une faible épaisseur, inférieure à 300nm et typiquement comprise entre 10nm et 200nm. Une telle épaisseur limite grandement les effets d'isolation thermique de la couche uniforme 23 dans la première région R1, justement celle dans laquelle un échauffement va se produire du fait de la présence de la source laser. Une couche uniforme 23 la plus fine possible est bien sûr avantageuse à l'aplomb de la première région R1, de manière à impacter le moins possible la dissipation thermique entre le premier guide d'onde 31 et le pavé monobloc en matériau conducteur thermique 21. Rappelons que le mode optique généré par la source laser et guidé dans le guide optique hybride, incluant le premier guide d'onde optique 31, est naturellement étiré vers le haut (vers l'empilement 40) et ne requiert donc pas une forte épaisseur de matériau de gainage optique pour se prémunir du couplage avec les matériaux inférieurs.

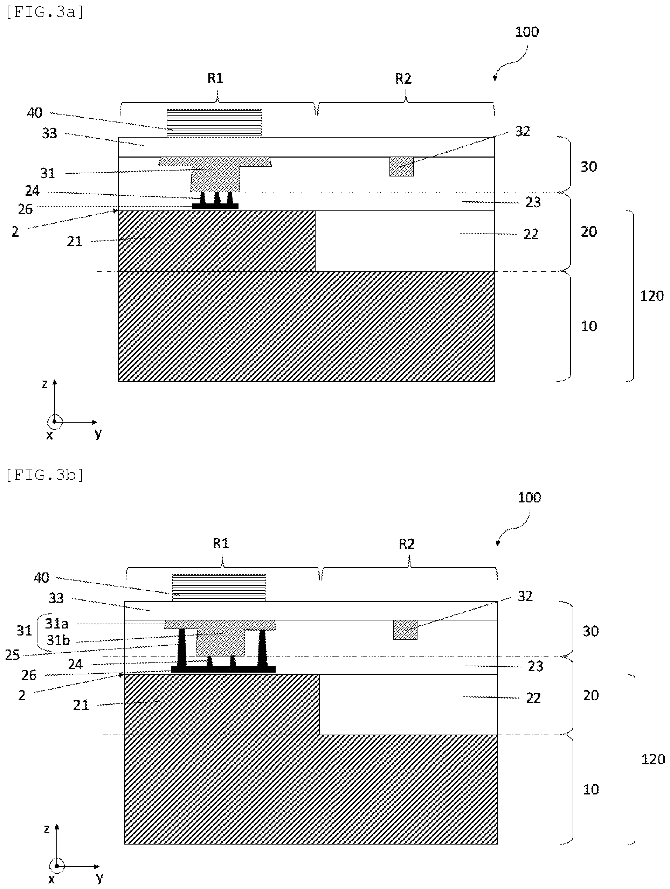

Selon des modes de réalisation particuliers, la couche optique 30 et/ou la couche intermédiaire 20 comprend(ennent) au moins un niveau d'interconnexion métallique pour former des contacts électriques d'un composant optique actif, et/ou pour former au moins un via de dissipation thermique 24,25,27 entre le premier guide d'onde 31 et le matériau conducteur thermique 21 (figures 3a à 3d). Lorsqu'il y a un niveau d'interconnexion métallique, la couche uniforme 23 peut être plus épaisse et contenir lesdits vias 24,25,27 et éventuellement des lignes de métal 26 connectées aux vias. Dans la couche optique 30, les vias 25 peuvent être en contact direct avec la base 31a du premier guide d'onde optique 31, ou en contact par l'intermédiaire d'un film (non représenté) par exemple isolant électrique de faible épaisseur, typiquement inférieure à 200nm. Dans la couche uniforme 23, incluse dans la couche intermédiaire 20, les vias de dissipation thermique 24,27 et/ou les lignes de métal 26 peuvent être en contact direct d'un côté avec la nervure centrale 31b du premier guide d'onde 31 et de l'autre côté avec le matériau conducteur thermique 21 ; alternativement, ils peuvent être en contact avec ces éléments par l'intermédiaire d'une faible épaisseur résiduelle (non représentée) de la couche continue 23, typiquement inférieure à 200nm.

Plusieurs modes de réalisation et variantes du dispositif photonique 100 vont maintenant être décrits en référence aux figures 1a, 2a à 2b et 3a à 3d.

Pour les différents modes de réalisation, le procédé de fabrication du dispositif photonique 100 comprend les étapes suivantes.

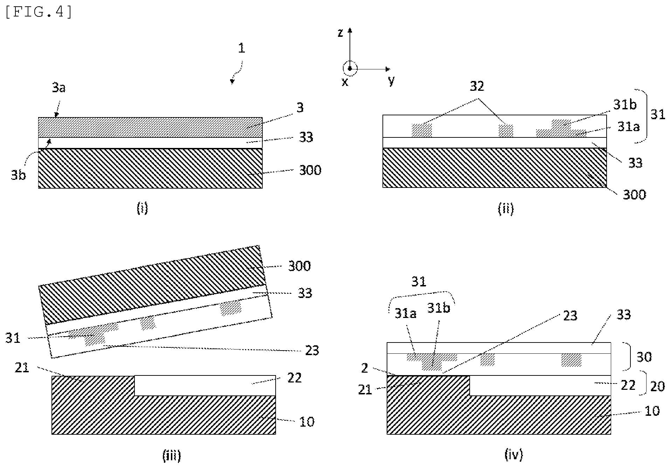

Une étape a) de fourniture d'un substrat SOI 1 comprenant une couche superficielle 3 en silicium monocristallin présentant une face avant 3a et une face arrière 3b, une couche diélectrique 33 enterrée disposée contre la face arrière 3b de la couche superficielle 3, et un substrat de base 300 (figure 4 (i)). La couche diélectrique 33 est en général en oxyde de silicium et le substrat de base 300 en silicium monocristallin. Le substrat SOI 1 se présente sous la forme d'une plaquette d'épaisseur comprise entre 300 microns et 1000 microns, et de diamètre compris entre 150mm et 450mm.

Le procédé comprend également une étape b) de fourniture d'une couche support 10. En général, on partira d'un substrat de silicium monocristallin se présentant sous la forme d'une plaquette d'épaisseur comprise entre 300 microns et 1000 microns, et de diamètre compris entre 150mm et 450mm.

L'étape c) suivante comprend l'élaboration d'au moins un premier guide d'onde optique 31 dans la couche superficielle 3 du substrat SOI 1 (figure 4 (ii)). Le premier guide d'onde 31 sera ultérieurement associé à un empilement de composés semi-conducteur III-V 40 pour former une source laser, dans une première région R1 s'étendant dans plan principal (x,y).

Le premier guide d'onde optique 31 peut prendre différentes formes. Il peut notamment former une base 31a s'étendant dans plan principal (x,y), de part et d'autre d'une nervure centrale 31b, comme illustré sur la figure 4(ii).

D'autres guides d'onde optiques, notamment au moins un deuxième guide d'onde optique 32, peuvent également être élaborés dans la couche superficielle 3 en silicium ou à proximité de celle-ci dans une deuxième région R2 s'étendant dans plan principal (x,y).

En général, des procédés classiques de photolithographie, gravure et/ou dépôt permettent de structurer ainsi la couche superficielle 3 du substrat SOI 1. Le guide d'onde 31 et autres composants 32 formés dans la couche superficielle 3 ou dans une couche, par exemple en nitrure de silicium, adjacente ou au-dessus (non représentée), sont ensuite encapsulés dans une couche d'encapsulation, habituellement en oxyde de silicium. Cette couche d'encapsulation peut présenter une épaisseur identique à l'épaisseur du guide d'onde 31 et affleurer au même niveau de surface que ledit guide d'onde 31. Elle peut éventuellement recouvrir totalement le premier guide d'onde 31 et le deuxième guide d'onde 32, comme cela est illustré sur la figure 4(ii). La partie de la couche d'encapsulation au-dessus du premier guide d'onde 31 est incluse dans la couche uniforme 23 évoquée dans un passage précédent relatif au dispositif photonique 100.

Comme cela sera décrit en référence aux modes particuliers de réalisation illustrés sur les figures 3a à 3d, au moins un niveau d'interconnexion métallique pourra également être élaboré à travers et/ou dans la couche d'encapsulation. Ledit niveau d'interconnexion a pour rôle de former des contacts électriques pour un (ou plusieurs) composant(s) optique(s) actif(s), et/ou de former au moins un via de dissipation thermique 24,25,27 entre le premier guide d'onde 31 et le matériau conducteur thermique 21.

Le procédé de fabrication comprend également une étape d) de formation d'une couche intermédiaire 20, disposée sur la couche optique 30 ou sur la couche support 10 ou partiellement sur la couche optique 30 et partiellement sur la couche support 10. C'est essentiellement cette étape d) qui distingue les différents modes de réalisation de l'invention, qui seront décrits plus bas.

Puis, une étape e) d'assemblage du substrat SOI 1 et de la couche support 10, le long d'une interface de collage 2, est opérée (figure 4 (iii)), pour former un ensemble collé. La couche intermédiaire 20 du dispositif photonique 100, incluant la couche uniforme 23, se trouve ainsi enterrée entre la couche optique 30 et la couche support 10. L'assemblage est préférentiellement basé sur un collage direct, par adhésion moléculaire c'est-à-dire ne nécessitant pas l'ajout d'une quelconque matière adhésive, mais pourrait alternativement mettre en oeuvre un collage adhésif.

Comme cela est bien connu en soi, on prendra soin de préparer les surfaces à assembler de sorte qu'elles présentent une très faible rugosité (typiquement inférieure à 0,5nm RMS) et un très faible niveau de contamination particulaire, organique et/ou métallique. Des techniques connues de polissage mécano-chimique, de nettoyage chimique, d'activation par plasma pourront notamment être mises en oeuvre pour la préparation des surfaces à assembler.

Notons que, dans le cas particulier où le matériau de gainage 22 est de l'air, le collage s'effectue avec des cavités à l'aplomb de la deuxième région R2.

Le procédé de fabrication comprend enfin une étape f) de retrait du substrat de base 300 de la structure SOI 1, pour ne laisser que la couche diélectrique 33 du côté de la face avant de la structure collée, la couche support 10 correspondant à sa face arrière (figure 4 (iv)).

L'étape g) ultérieure de formation de l'empilement 40 sur la couche diélectrique 33 peut être par exemple effectuée par assemblage entre une face dudit empilement 40 et la couche diélectrique 33, par exemple par collage direct ou adhésif.

Les étapes ultérieures de formation d'autres composants et de connexion électrique de la source laser ne sont pas décrites en détail ici. Notons que les autres composants pourront être de nature optique ou électro-optique.

Les étapes de singularisation sous forme de puce du dispositif photonique 100, par découpe de la structure finale, et les étapes de montage (« packaging ») ne sont pas non plus détaillées car conformes aux techniques connues de l'état de la technique.

### Premier mode de réalisation :

Revenant à la description des modes de réalisation particuliers, la figure 1a présente un dispositif photonique 100 selon un premier mode de réalisation de l'invention.

La couche intermédiaire 20 comprend :
- une couche uniforme 23 entre le premier guide d'onde 31 et le matériau conducteur thermique 21,
- une interface de collage 2,
- et une couche structurée (élaborée sur la couche support 10) constituée du matériau conducteur thermique 21 et du matériau de gainage optique 22.

La couche uniforme 23, déposée sur le premier guide d'onde 31 lors de l'étape d) du procédé de fabrication, est formée d'un matériau permettant de réaliser un gainage optique c'est-à-dire présentant un indice optique inférieur à celui du matériau formant le premier guide d'onde 31. Avantageusement, ce matériau est le même que le matériau de gainage optique 22. Préférentiellement la couche uniforme 23 fait partie de la couche d'encapsulation qui englobe le guide d'onde 31 et autres éléments 32 qui ont été formés dans la couche superficielle 3. De même que la couche d'encapsulation, la couche uniforme 23 peut donc être déposée sur le premier guide d'onde 31 de la structure SOI par une technique connue de dépôt, par exemple par dépôt chimique en phase vapeur, à l'étape d), préalablement à l'étape e) d'assemblage. Des étapes de polissage mécano-chimique et de nettoyage sont également réalisées pour assurer la planéité de la couche uniforme 23.

La couche structurée est élaborée en partant d'un substrat support 120 massif en silicium, sur la face avant duquel des zones sont gravées, puis remplies par le matériau de gainage optique 22 (ou laissées vides, dans le cas où le matériau de gainage optique 22 est de l'air). Là encore, des techniques connues de lithographie, gravure sèche ou humide, dépôt et potentiellement polissage sont mises en oeuvre pour la formation de la couche structurée. Les zones non gravées forment les pavés monoblocs de matériau conducteur thermique 21, en silicium, lesquels font ici partie intégrante du substrat support 120.

La localisation des zones gravées et des zones non gravées est définie de sorte que, après l'étape e) d'assemblage, les zones gravées soient en vis-à-vis de la deuxième région R2 de la couche optique 30, et les zones non gravées en vis-à-vis de la première région R1. Dans ce premier mode de réalisation, l'étape e) comprend donc une séquence d'alignement des substrats à assembler, préalablement à leur mise en contact pour collage, de manière à positionner les zones précitées du support 120 en vis-à-vis des régions associées de la couche optique 30.

La figure 1a présente le dispositif photonique 100 obtenu par le procédé de fabrication selon l'invention. La couche intermédiaire 20, entre la couche optique 30 et la couche support 10, comprend une couche uniforme 23, un matériau de gainage optique 22 et un matériau conducteur thermique 21 formant un pavé monobloc à l'aplomb de la première région R1. La présence de ce pavé et la faible épaisseur de la couche uniforme 23 favorisent la dissipation thermique de la chaleur qui sera générée, au niveau de la première région R1, par la source laser. La forte épaisseur de gainage, en vis-à-vis de la deuxième région R2, permet d'accommoder une grande variété d'autres composants optiques (guide d'onde, coupleur de lumière, détecteur, modulateur...) en limitant les couplages optiques ou capacitifs parasites avec la couche support 10.

Selon une variante du premier mode de réalisation illustré sur la figure 2a, la couche uniforme 23 peut être formée, à l'étape d) du procédé, partiellement du côté de la couche optique 30, sur le substrat SOI 1 et partiellement du substrat support 120, sur le matériau conducteur thermique 21 et sur le matériau de gainage 22 ; l'interface de collage 2 se retrouve alors dans la couche uniforme 23.

Selon une autre variante du premier mode de réalisation, le matériau conducteur thermique 21 ne fait pas partie intégrante du substrat support 120 mais est constitué d'un matériau déposé sur la couche support 10. Ledit matériau est dans ce cas choisi parmi les matériaux présentant une bonne conductibilité thermique.

### Deuxième mode de réalisation :

La figure 2b présente un dispositif photonique 100 selon le deuxième mode de réalisation de l'invention.

A l'étape d) du procédé, la couche intermédiaire 20 est intégralement élaborée du côté de la couche optique 30, à savoir sur les guides d'onde optique 31,32 du substrat SOI 1.

La couche intermédiaire 20 est composée de la couche uniforme 23, du matériau conducteur thermique 21 et du matériau de gainage optique 22.

Elle peut être élaborée, par exemple, par dépôt d'une couche homogène de matériau de gainage 22 sur les guides d'onde optique 31,32 du substrat SOI 1, puis par gravure de ce matériau de gainage 22 et dépôt local d'un matériau conducteur thermique 21 pour former un pavé monobloc à l'aplomb de la première région R1. La couche uniforme 23 est alors de même nature que le matériau de gainage 22.

Alternativement, après dépôt de la couche uniforme 23 sur les guides d'onde optique 31,32 du substrat SOI 1, le matériau conducteur thermique 21 est formé uniquement à l'aplomb de la première région R1. Le matériau de gainage 22 peut, quant à lui, être constitué d'air ; l'étape e) d'assemblage ultérieure s'opère donc avec des cavités dans la deuxième région R2.

Des techniques connues de lithographie, gravure sèche ou humide, dépôt et polissage peuvent être mises en oeuvre pour la formation d'une telle couche intermédiaire 20.

Selon ce deuxième mode de réalisation, la couche support 10 peut être assemblée directement (à l'étape e)) sur la couche intermédiaire 20 formée, sans nécessiter de séquence d'alignement car la couche support 10 est vierge de motifs.

La couche support 10 peut éventuellement comporter une couche de collage 11, pour faciliter l'assemblage.

Selon une variante, une couche de collage peut également être déposée sur la couche intermédiaire 20 avant son assemblage sur la couche support 10.

Ces couches de collage 11 pourront être formées en un matériau conducteur thermique (par exemple de même nature que le matériau conducteur thermique 21) ou isolant (par exemple de même nature que le matériau de gainage 22). Dans ce dernier cas, on prendra soin de limiter l'épaisseur (typiquement inférieure à 200nm) des couches de collage 11, pour ne pas affecter négativement la dissipation thermique entre le monobloc de matériau conducteur thermique 22 et la couche support 10.

### Troisième mode de réalisation :

Les figures 3a à 3d présentent des variantes d'un troisième mode de réalisation de l'invention, combinables aux autres modes de réalisation et variantes, qui se caractérise par la présence d'au moins un via de dissipation thermique 24,25,27 disposé entre le premier guide d'onde optique 31 et le pavé monobloc en matériau conducteur thermique 21.

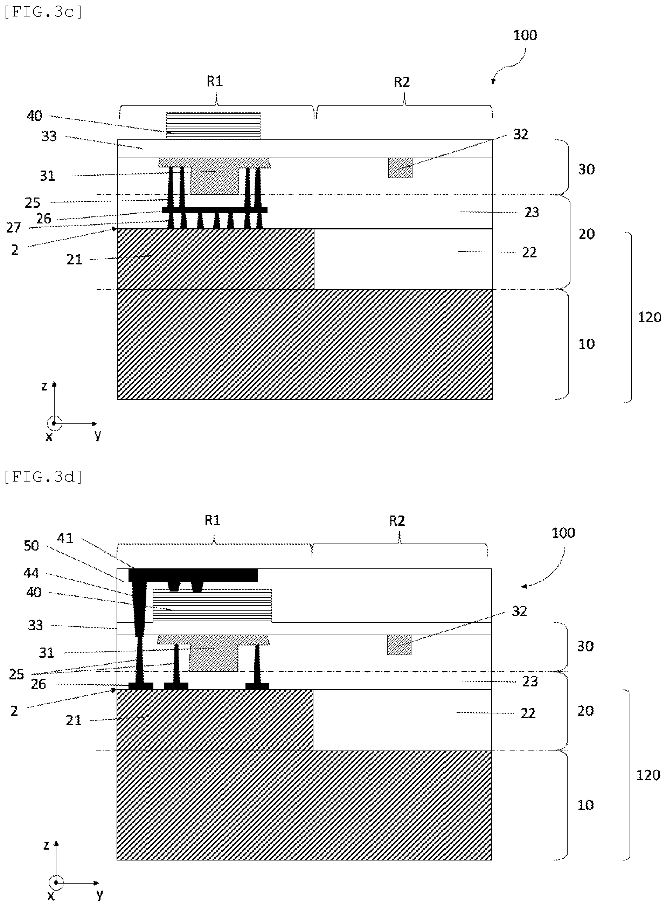

Dans l'exemple illustré sur la figure 3a, plusieurs vias 24 s'étendent entre la nervure centrale 31b du premier guide d'onde 31 et ledit pavé 21. Sur la figure 3b, d'autres vias 25 s'étendent de la base 31a du premier guide d'onde 31 vers le pavé monobloc en matériau conducteur thermique 21. On pourra également imaginer que des vias 25 s'étendent uniquement entre la base 31a et le pavé 21. Des lignes de métal 26 peuvent également être présentes, connectant entre eux plusieurs ou tous les vias 24,25, pour augmenter leur capacité de conductibilité thermique.

Selon une autre variante illustrée sur la figure 3c, des vias de dissipation thermique 25 s'étendent de la base 31a du premier guide d'onde 31 jusqu'à une ligne de métal 26, et d'autres vias de dissipation 27 s'étendent ensuite vers le pavé monobloc en matériau conducteur thermique 21.

Les vias 24,25,27 peuvent être directement en contact avec le guide d'onde 31 et/ou avec le matériau conducteur thermique 21 ; alternativement, un film isolant électrique (non représenté) peut exister entre les vias 24,25,27 et le guide d'onde 31, ainsi qu'entre les vias 24,25,27 et le matériau conducteur thermique 21. Le film isolant présente une très faible épaisseur (typiquement inférieure à 200 nm) pour n'avoir qu'un impact négligeable sur le chemin thermique.

Le (ou les) via(s) de dissipation thermique 24,25,27 est(sont) constitué(s) d'un matériau présentant une conductibilité thermique élevée. A titre d'exemple, on peut citer le tungstène, l'aluminium ou le cuivre. A titre d'exemple, un via peut présenter une section dans le plan principal (x,y) de l'ordre de 0,4x0,4 micron carré.

Les vias de dissipation thermique 24,25,27 sont élaborés, lors de l'étape d) du procédé de fabrication selon l'invention, à partir de techniques classiques de gravure et remplissage de tranchées. Notons que les vias 24,25,27 précitées peuvent faire partie d'un niveau d'interconnexion métallique destiné à former des contacts électriques d'un composant optique actif du dispositif photonique 100.

Le troisième mode de réalisation illustré sur les figures 3a à 3d prévoit une constitution de la couche intermédiaire 20 similaire à celle du premier mode de réalisation, avec en plus la présence de vias de dissipation thermique 24,25,27 et potentiellement de lignes de métal 26.

La couche intermédiaire 20, entre la couche optique 30 et la couche support 10, comprend un matériau de gainage optique 22 et un matériau conducteur thermique 21 formant un pavé monobloc à l'aplomb de la première région R1. Le -au moins un- via de dissipation thermique 24,25,27 disposé, dans la première région R1, entre le premier guide d'onde 31 et le pavé monobloc 21 améliore encore les propriétés de dissipation thermique.

La figure 3d propose une autre variante du troisième mode de réalisation qui intègre au moins un autre via de dissipation thermique 44 (dit deuxième via 44) entre l'empilement en composés semi-conducteurs III-V 40 et un via de dissipation thermique 25 (dit premier via 25) sous-jacent, s'étendant dans la couche optique 30. Après assemblage de l'empilement 40 sur la couche diélectrique 33, à l'aplomb du premier guide d'onde optique 31 et dans la première région R1, une couche de revêtement 50 est formée sur et potentiellement autour de l'empilement 40. Au moins un contact métallique 41 est réalisé sur la couche supérieure de l'empilement 40, lequel est relié par le deuxième via 44 à un premier via 25. La présence de ce deuxième via 44 améliore également la dissipation thermique vers le pavé monobloc 21.

A noter également que le premier guide d'onde optique 31 a été illustré dans une forme particulière avec une base 31a et une nervure centrale 31b, mais qu'il pourrait prendre toute forme ou configuration connue pour les guides d'onde optique.

Bien-sûr, l'invention n'est pas limitée aux modes de réalisation et variantes décrits, on peut y apporter d'autres variantes de réalisation sans sortir du cadre de l'invention tel que défini par les revendications.

## Revendications

1. Dispositif photonique (100) comprenant :
- une couche support (10),
- une couche optique (30) s'étendant selon un plan principal (x,y), subdivisée au moins en une première région (R1) et une deuxième région (R2) adjacentes dans ledit plan principal (x,y), et comportant un premier guide d'onde optique (31) dans la première région (R1) et un deuxième guide d'onde optique (32) dans la deuxième région (R2),
- un empilement (40) en composés semi-conducteurs III-V, disposé sur une couche diélectrique (33), elle-même disposée sur le premier guide d'onde (31), dans la première région (R1), l'empilement (40) formant avec le premier guide d'onde optique (31) une source laser,
- une couche intermédiaire (20), entre la couche optique (30) et la couche support (10), comprenant un matériau conducteur thermique (21) formant un pavé monobloc, disposé à l'aplomb de la première région (R1) et un matériau de gainage optique et/ou électrique (22) disposé à l'aplomb de la deuxième région (R2),
**caractérisé en ce que**
la couche optique (30) et/ou la couche intermédiaire (20) comprennent au moins un niveau d'interconnexion métallique pour former des contacts électriques d'un composant optique actif, et/ou pour former au moins un via de dissipation thermique (24,25,27) entre le premier guide d'onde (31) et le matériau conducteur thermique (21).

2. Dispositif photonique (100) selon la revendication précédente, dans lequel le matériau conducteur thermique (21) présente une conductibilité thermique supérieure ou égale à 10 W/m/K, à 20 W/m/K, à 50 W/m/K, voire à 100 W/m/K.

3. Dispositif photonique (100) selon l'une des revendications précédentes, dans lequel le matériau de gainage (22) est choisi parmi l'oxyde de silicium ou l'air, et le matériau conducteur thermique (21) est choisi parmi le silicium, le nitrure de silicium, le cuivre, le nitrure d'aluminium, l'aluminium, l'alumine.

4. Dispositif photonique (100) selon l'une des revendications précédentes, dans lequel le premier guide d'onde optique (31) comprend du silicium monocristallin, du silicium amorphe et/ou du nitrure de silicium.

5. Dispositif photonique (100) selon l'une des revendications précédentes, dans lequel la couche support (10) est en silicium monocristallin.

6. Dispositif photonique (100) selon l'une des revendications précédentes, dans lequel le matériau conducteur thermique (21) et le matériau de gainage (22) présentent une épaisseur comprise entre 100nm et 5 microns, préférentiellement entre 300nm et 3 microns.

7. Dispositif photonique (100) selon l'une des revendications précédentes, comprenant une interface de collage (2) s'étendant parallèlement au plan principal (x,y), située dans la couche intermédiaire (20), ou entre la couche intermédiaire (20) et la couche support (10), ou entre la couche intermédiaire (20) et la couche optique (30).

8. Dispositif photonique (100) selon l'une des revendications précédentes, dans lequel le deuxième guide d'onde (32) fait partie d'un composant optique passif, tel qu'un coupleur de lumière par la tranche, ou d'un composant optique actif, tel qu'un détecteur ou un modulateur.

9. Dispositif photonique (100) selon l'une des revendications précédentes, comprenant au moins un via de dissipation thermique (44) entre l'empilement semi-conducteur (40) et le niveau d'interconnexion métallique.

10. Dispositif photonique (100) selon l'une des revendications précédentes, dans lequel le -au moins un-via de dissipation thermique (24,25,27,44) comprend un matériau choisi parmi le tungstène, l'aluminium ou le cuivre.

11. Procédé de fabrication d'un dispositif photonique (100) selon l'une des revendications précédentes, comprenant les étapes suivantes :
a) la fourniture d'un substrat silicium sur isolant (1) comprenant une couche superficielle (3) en silicium monocristallin présentant une face avant (3a) et une face arrière (3b), une couche diélectrique (33) enterrée disposée contre la face arrière (3b) de la couche superficielle (3), et un substrat de base (300) ;
b) la fourniture d'une couche support (10) ;
c) l'élaboration d'une couche optique (30) comprenant :
- un premier guide d'onde optique (31) dans une première région (R1), ledit guide d'onde étant formé dans la couche superficielle (3),
- un deuxième guide d'onde optique (32), dans une deuxième région (R2) ;
d) la formation d'une couche intermédiaire (20) disposée sur la couche optique (30) ou sur la couche support (10) ou partiellement sur la couche optique (30) et partiellement sur la couche support (10), ladite couche intermédiaire (20) comprenant un matériau conducteur thermique (21) formant un pavé monobloc, et un matériau de gainage optique et/ou électrique (22) ;
e) l'assemblage du substrat silicium sur isolant (1) et de la couche support (10) le long d'une interface de collage (2), la couche intermédiaire (20) étant disposée entre la couche support (10) et la couche optique (30), le matériau conducteur thermique (21) étant disposé à l'aplomb de la première région (R1) et le matériau de gainage optique et/ou électrique (22) étant disposé à l'aplomb de la deuxième région (R2) ;
f) le retrait du substrat de base (300) ;
g) la formation de l'empilement (40) sur la couche diélectrique (33), dans la première région (R1).

12. Procédé de fabrication selon la revendication précédente, dans lequel la formation de la couche intermédiaire (20) sur la couche support (10) de l'étape d) comprend :
- une gravure locale de la couche support (10), dans une zone destinée à être assemblée en vis-à-vis de la deuxième région (R2) de la couche superficielle lors de l'étape e), et
- optionnellement, un dépôt d'un matériau de gainage (22) dans la zone gravée.

13. Procédé de fabrication selon la revendication précédente, dans lequel une couche de collage est déposée sur la couche intermédiaire (20) et/ou sur la couche optique (30), préalablement à l'étape e) d'assemblage.

## Patentansprüche

1. Photonische Vorrichtung (100), umfassend:
- eine Trägerschicht (10),
- eine optische Schicht (30), die sich entlang einer Hauptebene (x, y) erstreckt, mindestens in einen ersten Bereich (R1) und einen zweiten Bereich (R2) unterteilt ist, die in der Hauptebene (x, y) angrenzend sind, und einen ersten Lichtwellenleiter (31) in dem ersten Bereich (R1) und einen zweiten Lichtwellenleiter (32) in dem zweiten Bereich (R2) aufweist, - einen Stapel (40) aus III-V-Halbleiterverbindungen, der auf einer dielektrischen Schicht (33) angeordnet ist, die selbst auf dem ersten Wellenleiter (31) angeordnet ist, in dem ersten Bereich (R1), wobei der Stapel (40) mit dem ersten optischen Wellenleiter (31) eine Laserquelle ausbildet, - eine Zwischenschicht (20), zwischen der optischen Schicht (30) und der Trägerschicht (10), umfassend ein wärmeleitendes Material (21), das einen einstückigen Block ausbildet, das senkrecht zu dem ersten Bereich (R1) angeordnet ist, und ein optisches und/oder elektrisches Hüllmaterial (22), das senkrecht zu dem zweiten Bereich (R2) angeordnet ist,
**dadurch gekennzeichnet, dass** die optische Schicht (30) und/oder die Zwischenschicht (20) mindestens eine Metallverbindungsebene zum Ausbilden elektrischer Kontakte einer aktiven optischen Komponente und/oder zum Ausbilden mindestens einer Wärmeableitungsdurchkontaktierung (24, 25, 27) zwischen dem ersten Wellenleiter (31) und dem wärmeleitenden Material (21) umfassen.

2. Photonische Vorrichtung (100) nach dem vorstehenden Anspruch, wobei das wärmeleitende Material (21) eine Wärmeleitfähigkeit größer als oder gleich 10 W/m/K, 20 W/m/K, 50 W/m/K oder sogar 100 W/m/K vorweist.

3. Photonische Vorrichtung (100) nach einem der vorstehenden Ansprüche, wobei das Hüllmaterial (22) aus Siliziumoxid oder Luft ausgewählt ist und das wärmeleitende Material (21) aus Silizium, Siliziumnitrid, Kupfer, Aluminiumnitrid, Aluminium, Aluminiumoxid ausgewählt ist.

4. Photonische Vorrichtung (100) nach einem der vorstehenden Ansprüche, wobei erste optische Wellenleiter (31) monokristallines Silizium, amorphes Silizium und/oder Siliziumnitrid umfasst.

5. Photonische Vorrichtung (100) nach einem der vorstehenden Ansprüche, wobei die Trägerschicht (10) aus monokristallinem Silizium besteht.

6. Photonische Vorrichtung (100) nach einem der vorstehenden Ansprüche, wobei das wärmeleitende Material (21) und das Hüllmaterial (22) eine Dicke zwischen 100 nm und 5 Mikrometern, vorzugsweise zwischen 300 nm und 3 Mikrometern, vorweisen.

7. Photonische Vorrichtung (100) nach einem der vorstehenden Ansprüche, umfassend eine Bindungsschnittstelle (2), die sich parallel zu der Hauptebene (x,y) erstreckt, die sich in der Zwischenschicht (20) oder zwischen der Zwischenschicht (20) und der Trägerschicht (10) oder zwischen der Zwischenschicht (20) und der optischen Schicht (30) befindet.

8. Photonische Vorrichtung (100) nach einem der vorstehenden Ansprüche, wobei der zweite Wellenleiter (32) Teil einer passiven optischen Komponente, beispielsweise eines Kantenlichtkopplers, oder einer aktiven optischen Komponente, beispielsweise eines Detektors oder Modulators, ist.

9. Photonische Vorrichtung (100) nach einem der vorstehenden Ansprüche, umfassend mindestens eine Wärmeableitungsdurchkontaktierung (44) zwischen dem Halbleiterstapel (40) und der Metallverbindungsebene.

10. Photonische Vorrichtung (100) nach einem der vorstehenden Ansprüche, wobei die - mindestens eine - Wärmeableitungsdurchkontaktierung (24, 25, 27, 44) ein Material umfasst, das aus Wolfram, Aluminium oder Kupfer ausgewählt ist.

11. Verfahren zum Herstellen einer photonischen Vorrichtung (100) nach einem der vorstehenden Ansprüche, umfassend die folgenden Schritte:
a) Bereitstellen eines Silizium-auf-Isolator-Substrats (1), umfassend eine Oberflächenschicht (3) aus monokristallinem Silizium, die eine Vorderseite (3a) und eine Rückseite (3b), eine versenkte dielektrische Schicht (33), die an der Vorderseite (3b) der Oberflächenschicht (3) angeordnet ist, und ein Basissubstrat (300) vorweist;
b) Bereitstellen einer Trägerschicht (10);
c) Erstellen einer optischen Schicht (30), umfassend:
- einen ersten optischen Wellenleiter (31) in einem ersten Bereich (R1), wobei der Wellenleiter in der Oberflächenschicht (3) ausgebildet ist,
- einen zweiten optischen Wellenleiter (32), in einem zweiten Bereich (R2);
d) das Bilden einer Zwischenschicht (20), die auf der optischen Schicht (30) oder auf der Trägerschicht (10) oder teilweise auf der optischen Schicht (30) und teilweise auf der Trägerschicht (10) angeordnet ist, die Zwischenschicht (20) umfassend ein wärmeleitendes Material (21), das einen einteiligen Block ausbildet, und ein optisches und/oder elektrisches Hüllmaterial (22);
e) Montieren des Silizium-auf-Isolator-Substrats (1) und der Trägerschicht (10) entlang einer Bindungsschnittstelle (2), wobei die Zwischenschicht (20) zwischen der Trägerschicht (10) und der optischen Schicht (30) angeordnet ist, wobei das wärmeleitende Material (21) senkrecht zu dem ersten Bereich (R1) und das optische und/oder elektrische Hüllmaterial (22) senkrecht zu dem zweiten Bereich (R2) angeordnet ist;
f) Entfernen des Basissubstrats (300);
g) Ausbilden des Stapels (40) auf der dielektrischen Schicht (33) in dem ersten Bereich (R1).

12. Herstellungsverfahren nach dem vorstehenden Anspruch, wobei das Ausbilden der Zwischenschicht (20) auf der Trägerschicht (10) von Schritt d) umfasst:
- lokales Ätzen der Trägerschicht (10) in einer Zone, die dazu bestimmt ist, während Schritt e) gegenüber dem zweiten Bereich (R2) der Oberflächenschicht montiert zu werden, und
- optional Abscheiden eines Hüllmaterials (22) in der geätzten Zone.

13. Herstellungsverfahren nach dem vorstehenden Anspruch, wobei vor dem Montageschritt e) eine Bindungsschicht auf der Zwischenschicht (20) und/oder auf die optische Schicht (30) abgeschieden wird.

## Claims

1. Photonic device (100) comprising:
- a support layer (10),
- an optical layer (30) extending in a main plane (x, y), subdivided into at least a first region (R1) and a second region (R2) which are adjacent in said main plane (x, y), and comprising a first optical waveguide (31) in the first region (R1) and a second optical waveguide (32) in the second region (R2),
- a stack (40) of III-V semiconductor compounds, arranged on a dielectric layer (33), which is itself arranged on the first waveguide (31), in the first region (R1), the stack (40) forming a laser source with the first optical waveguide (31),
- an intermediate layer (20), between the optical layer (30) and the support layer (10), comprising a thermally conductive material (21) forming a single-piece block, arranged in line with the first region (R1), and an optical and/or electrical cladding material (22) arranged in line with the second region (R2),
**characterized in that** the optical layer (30) and/or the intermediate layer (20) comprise at least one metal interconnection level to form electrical contacts of an active optical component, and/or to form at least one heat dissipation via (24, 25, 27) between the first waveguide (31) and the thermally conductive material (21).

2. Photonic device (100) according to the preceding claim, wherein the thermally conductive material (21) has a thermal conductivity greater than or equal to 10 W/m/K, to 20 W/m/K, to 50 W/m/K, or to 100 W/m/K.

3. Photonic device (100) according to one of the preceding claims, wherein the cladding material (22) is chosen from silicon oxide or air, and the thermally conductive material (21) is chosen from silicon, silicon nitride, copper, aluminum nitride, aluminum, alumina.

4. Photonic device (100) according to one of the preceding claims, wherein the first optical waveguide (31) comprises monocrystalline silicon, amorphous silicon and/or silicon nitride.

5. Photonic device (100) according to one of the preceding claims, wherein the support layer (10) is made of monocrystalline silicon.

6. Photonic device (100) according to one of the preceding claims, wherein the thermally conductive material (21) and the cladding material (22) have a thickness of between 100 nm and 5 microns, preferably between 300 nm and 3 microns.

7. Photonic device (100) according to one of the preceding claims, comprising a bonding interface (2) extending in parallel with the main plane (x, y), located in the intermediate layer (20), or between the intermediate layer (20) and the support layer (10), or between the intermediate layer (20) and the optical layer (30).

8. Photonic device (100) according to one of the preceding claims, wherein the second waveguide (32) forms part of a passive optical component, such as an edge coupler, or an active optical component, such as a detector or a modulator.

9. Photonic device (100) according to one of the preceding claims, comprising at least one heat dissipation via (44) between the semiconductor stack (40) and the metal interconnection level.

10. Photonic device (100) according to one of the preceding claims, wherein the -at least one- heat dissipation via (24, 25, 27, 44) comprises a material chosen from tungsten, aluminum or copper.

11. Method for producing a photonic device (100) according to one of the preceding claims, comprising the following steps:
a) providing a silicon on insulator substrate (1) comprising a surface layer (3) made of monocrystalline silicon having a front face (3a) and a rear face (3b), a buried dielectric layer (33) arranged against the rear face (3b) of the surface layer (3), and a base substrate (300);
b) providing a support layer (10);
c) preparing an optical layer (30) comprising:
- a first optical waveguide (31) in a first region (R1), said waveguide being formed in the surface layer (3),
- a second optical waveguide (32), in a second region (R2);
d) forming an intermediate layer (20) arranged on the optical layer (30) or on the support layer (10) or partially on the optical layer (30) and partially on the support layer (10), said intermediate layer (20) comprising a thermally conductive material (21) forming a single-piece block, and an optical and/or electrical cladding material (22);
e) assembling the silicon on insulator substrate (1) and the support layer (10) along a bonding interface (2), the intermediate layer (20) being arranged between the support layer (10) and the optical layer (30), the thermally conductive material (21) being arranged in line with the first region (R1) and the optical and/or electrical cladding material (22) being arranged in line with the second region (R2);
f) removing the base substrate (300);
g) forming the stack (40) on the dielectric layer (33), in the first region (R1).

12. Production method according to the preceding claim, wherein the forming of the intermediate layer (20) on the support layer (10) in step d) comprises:
- local etching of the support layer (10), in an area intended to be assembled facing the second region (R2) of the surface layer during step e), and
- optionally, depositing a cladding material (22) in the etched area.

13. Production method according to the preceding claim, wherein a bonding layer is deposited on the intermediate layer (20) and/or on the optical layer (30), prior to the assembly step e).
